# EUROPEAN PATENT APPLICATION

(11) **EP 3 696 745 A1**
(43) Date of publication of application: **19.08.2020**
(21) Application number: 19182190.9
(22) Date of filing: 25.06.2019
(51) Int. Cl.: G06Q 10/06, G06Q 50/04

(54) **INTELLIGENT WORKFLOW ADVISOR FOR PART DESIGN, SIMULATION AND MANUFACTURE**

(30) Priority: 15.02.2019 US 201916277035
(71) Applicant: Siemens Industry Software Inc., Plano, TX 75024-6612 (US)
(72) Inventor: SRIVASTAVA, Sanjeev, Princeton Junction, NJ 08550 (US)
(74) Representative: Horn Kleimann Waitzhofer Patentanwälte PartG mbB

(57) **Abstract**

Methods for automatic creation of workflows for design or simulation of a product to be manufactured and corresponding systems and computer-readable mediums. A method includes tracking (408) a current workflow (106), by a data processing system (500), to produce current workflow data (554). The method includes converting (410) the current workflow data (554) into current workflow knowledge (556). The method includes predicting (412) next actions for the current workflow (106), based on the current workflow knowledge (556) and a contextual knowledge graph (144), to produce an automatically created workflow (138). The method includes implementing (416) the automatically created workflow (138).

## Description

### TECHNICAL FIELD

The present disclosure is directed, in general, to systems and methods for part design and manufacture, and in particular for systems and methods for intelligent and automated workflow creation for part design and manufacture.

### BACKGROUND OF THE DISCLOSURE

Conventional design processes include user workflows that require repeated tasks that may be similar to tasks performed in similar contexts. Current product-design systems do not address these issues. Improved systems are desirable.

### SUMMARY OF THE DISCLOSURE

Various disclosed embodiments include methods for automatic creation of workflows for design or simulation of a product to be manufactured. A method includes tracking a current workflow, by a data processing system, to produce current workflow data. The method includes converting the current workflow data into current workflow knowledge. The method includes predicting next actions for the current workflow based on the current workflow knowledge and a contextual knowledge graph to produce an automatically created workflow. The method includes implementing the automatically created workflow.

The method can also include processes performed to create the contextual knowledge graph. These processes include receiving past workflow data by the data processing system. These processes include converting the past workflow data, by the data processing system, into workflow knowledge. These processes include storing the workflow knowledge in the contextual knowledge graph.

In various embodiments, the current workflow is a series of actions to be performed in the design process, manufacturing planning, or simulation setup of a part to be manufactured. In some embodiments, converting the past workflow data includes contextualizing actions in the past workflow data with other associative actions in the past workflow data and adding parametric information associated with each action in the past workflow data. In some embodiments, the past workflow data includes one or more of a log file, a feature tree, CAD data, interaction capture, a requirement, and a configuration. In some embodiments, the past workflow data includes a series of actions that were performed in the design of a previous part to be manufactured. In some embodiments, the past workflow data includes data needed to perform the series of actions that were performed in the design process of the previous part to be manufactured, including one or more of requirements, configurations, log files, simulation and modelling data. In some embodiments, the contextual knowledge graph is repeatedly modified to include different workflow knowledge.

The foregoing has outlined rather broadly the features and technical advantages of the present disclosure so that those skilled in the art may better understand the detailed description that follows. Additional features and advantages of the disclosure will be described hereinafter that form the subject of the claims. Those skilled in the art will appreciate that they may readily use the concepts and the specific embodiments disclosed as a basis for modifying or designing other structures for carrying out the same purposes of the present disclosure. Those skilled in the art will also realize that such equivalent constructions do not depart from the spirit and scope of the disclosure in its broadest form.

Before undertaking the DETAILED DESCRIPTION below, it may be advantageous to set forth definitions of certain words or phrases used throughout this patent document: the terms "include" and "comprise," as well as derivatives thereof, mean inclusion without limitation; the term "or" is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, whether such a device is implemented in hardware, firmware, software or some combination of at least two of the same. It should be noted that the functionality associated with any particular controller may be centralized or distributed, whether locally or remotely. Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects, and in which:
Figure 1 illustrates major components of a workflow advisor system in accordance with disclosed embodiments;
Figure 2 illustrates an example of a contextual knowledge graph in accordance with disclosed embodiments;
Figure 3 illustrates an example of a node data structure of the contents of node in accordance with disclosed embodiments;
Figure 4 illustrates a process in accordance with disclosed embodiments; and
Figure 5 illustrates a block diagram of a data processing system in which an embodiment can be implemented.

### DETAILED DESCRIPTION

The Figures discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

Modeling and simulation for the purpose of design and analysis is a time-consuming process. This problem is exacerbated when the software being used for the modeling and simulation process is complex. In such cases, an engineer performs modeling actions, via an interaction with the system within the software, that are quite repetitive and exhibit "design" patterns. Moreover, many a times an engineer must create models and set up simulations that are either only slightly different than past efforts. In other cases, when a new model is quite different from previous solutions, subsets of various steps performed in the new workflow are similar to those performed in the past workflow with variations only in the values of the chosen parameters.

Disclosed embodiments provide improved systems and methods that reduce and partially automate the repetitive tasks during a modeling and simulation workflow. Based on the past designs and model creation data, patterns implicit in the workflow performed in the act of modeling or simulation can be learned by the system and then utilized by the system to predict the next steps in the current workflow being performed by an engineer. The "current" workflow refers to the workflow that a user and system are currently or about to perform via the user's interaction with the system, which may be a new workflow but is similar to previous workflows in whole or in part, as described herein.

Other systems address workflow or engineering workflow automation through software in which a user can use pre-designed GUI components to realize a workflow that can be executed automatically. None of these solutions, however, can learn from or apply past design or modeling workflow data and use that data to predict the steps in the workflow being currently performed by an engineer in a product design process.

Disclosed embodiments can automatically capture knowledge and experiences of a design engineer, for example based on how they interact with engineering tools in the system. Disclosed embodiments can encode that knowledge in a "representation" contextual knowledge graph that the system then uses to predict the steps of current workflow that might be performed by the same or another design engineer.

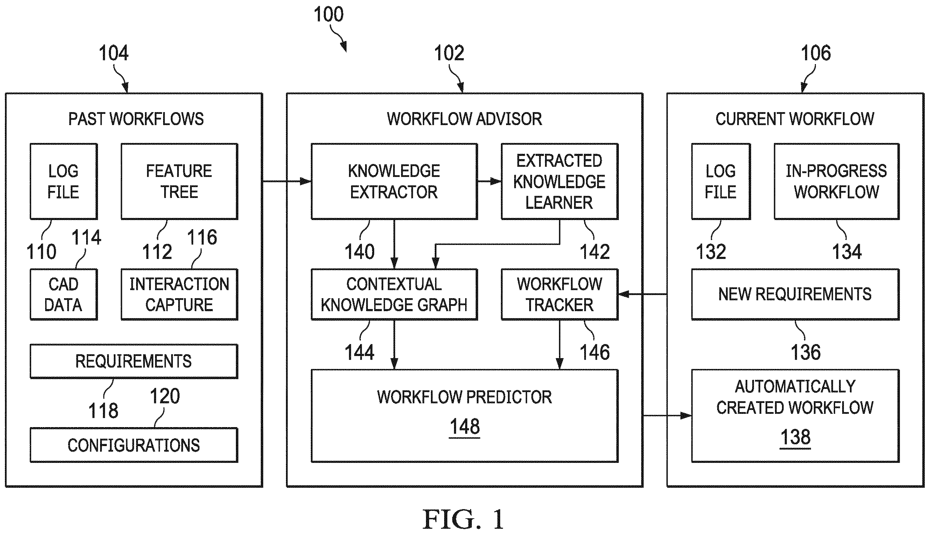

Figure 1 illustrates major components of a workflow advisor system 100 in accordance with disclosed embodiments, as can be implemented by one or more data processing systems as disclosed herein.

As described herein, a workflow advisory system 100 implements a workflow advisor 102 that interacts with past workflows 104 and a current workflow 106. A "workflow" refers to the series of tasks required to be performed in the design, simulation, or manufacturing process of a part to be manufactured, and can include the data need to perform the tasks, including requirements, configurations, log files, simulation and modelling data, and otherwise.

The past workflows 104 can include log files 110, feature trees 112, CAD data 114, interaction capture 116, requirements 118, and configurations 120, among other data. Current workflow 106 can include log file 132, in-progress workflow 134, new requirements 136, and the automatically-created workflow 138, among other data. Elements of the workflow advisor 102 can include a knowledge extractor 140, an extracted knowledge learner 142, a contextual knowledge graph 144, a workflow tracker 146, and a workflow predictor 148, each of which can be implemented as separate or integral software functional modules and are used to implement specific functionality performed by the system.

Knowledge extractor 140 extracts relevant knowledge from various sources from past workflows 104 regarding the simulation or design workflow for the current workflow 106. For example, in the case of the NX software product of Siemens Product Lifecycle Management Software Inc. (Plano, TX), any modeling, simulation, or manufacturing process will generate several sources of workflow data. Some possible data sources included in past workflows 104, in various embodiments, include log file 110 that captures actions performed by the user; CAD data 114, which can include a geometric model, parametric data, geometric data, and other data; a feature tree 112 corresponding to (or included with CAD data 114); requirements 118; configurations 120, and interaction capture 116 that can include, for example, a screen capture that captures, in video format, the actions performed by the user or data sufficient to analyze or reproduce each user interaction including keypresses, mouse clicks, and other inputs with respect to user interface elements.

Knowledge extractor 140 can receive data from past workflows 104, convert this data, and add the converted data to contextual knowledge graph 144. For example, from the log file 110, various high-level actions performed by the user (such as extrude, sketch, insert, etc.) can be extracted and converted into knowledge by contextualizing these actions with other associative actions and by adding the parametric information associated with this action. This generated knowledge can then be added as a new node with relevant edges in the contextual knowledge graph 144. The new node can be, for example, an instantiation of a pre-exiting class node or a new class node. In the case of requirements 118 and interaction capture 116, the system can use techniques such as Natural Language Processing (NLP) and machine learning (ML) driven motion capture and vision analytics tools, respectively.

The extracted knowledge learner 142 can receive the extracted knowledge generated from the past data by knowledge extractor 140 and then generate new rules or new knowledge from this data. For example, from the past workflows 104, extracted knowledge learner 142 can determine that a user always performs "action A" before "action B", thus learning design rules that can be applied to future workflows. As another example, extracted knowledge learner 142 can determine that a user usually performs specific sequences of actions within the software tool in order to create a specific type of geometry, when the same geometry can be created in many different ways using the various options provided by the software tool. In the second example, extracted knowledge learner 142 can determine a user preference of choice of actions to achieve a specific objective. This derived knowledge can then be added to contextual knowledge graph 144 in the form of, for example, a new edge (connection between the existing nodes) or a new node.

The system uses contextual knowledge graph 144 to capture knowledge about the simulation and modeling system. Contextual knowledge graph 144 contains the knowledge regarding various aspects of the simulation system such as configuration, system states, options, etc. Contextual knowledge graph 144 is dynamic in nature and it gets modified with time and new knowledge.

Workflow tracker 146 tracks the current workflow progress, for example by tracking log file 132, in-progress workflow 134, new requirements 136, and/or other data of current workflow 106, and extracts the relevant knowledge. Workflow tracker 146 differs from knowledge extractor 140 in the sense that workflow tracker 146 does not create or derive any new knowledge, but rather uses the knowledge definition embedded in the knowledge graph to extract the knowledge at runtime from current workflow 106.

Workflow predictor 148 uses the series of knowledge extracted from the current flow to detect user action patterns and then uses contextual knowledge graph 144 and an inference engine to predict the next possible actions that a user might take. Workflow predictor 148 can, either automatically or after the user accepts the predicted actions, then implement all the selected/predicted actions.

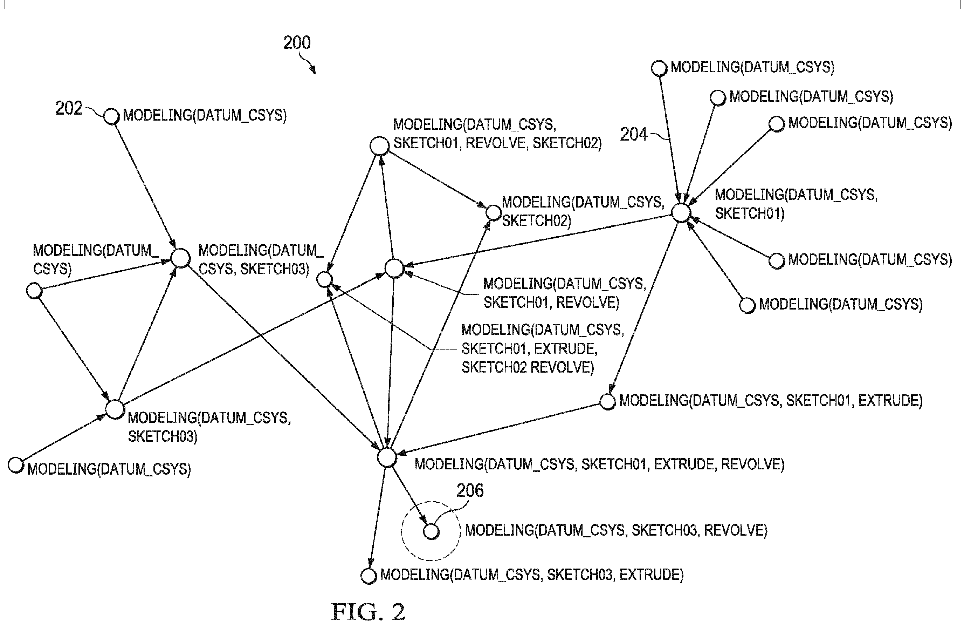

Figure 2 illustrates an example of a contextual knowledge graph 200 including multiple nodes 202 connected by edges 204 representing a design process/workflow for a part. Each node 202 can include knowledge regarding various aspects of the simulation system and workflow such as configuration, system states, options, operations, objects, relationships, or other data.

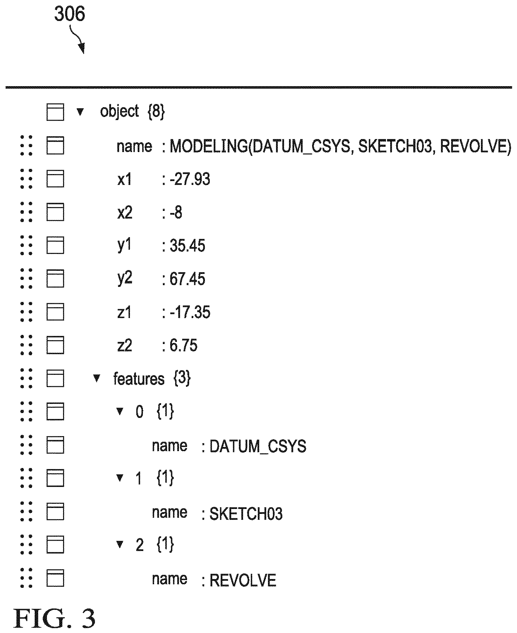

Figure 3 illustrates an example of a node data structure 306 of the contents of node 206 shown in the example of Fig. 2. Node data structure 306 represents a "modeling" node, and includes information for three features which include, in this example, DATUS_CSYS, SKETCH03, and REVOLVE.

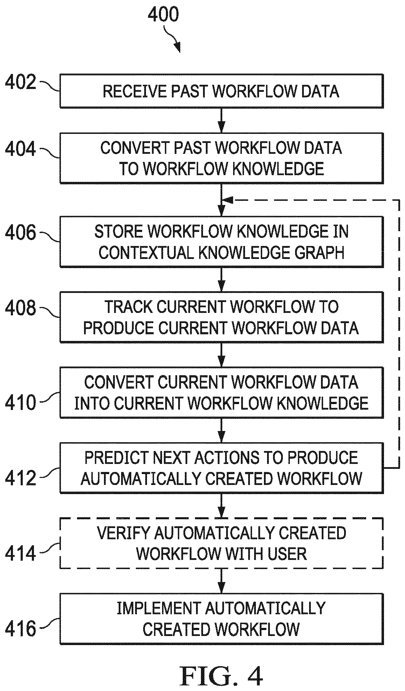

Figure 4 illustrates a process 400 in accordance with disclosed embodiments that can be performed in and by a system as described above, referred to generically as the "system" below. The system can include one or more individual data processing systems that together perform the processes described herein. The process illustrated in Fig. 4 can be combined with or implemented in conjunction with any other processes or devices as described above. At any point, the system can store or display the data or results of any particular process.

The system receives past workflow data (402). "Receiving," as used herein, can include loading from storage, receiving from another device or process, receiving via an interaction with a user, or otherwise.

In particular, to receive the past workflow data in some embodiments, the system actively monitors a used interaction to capture the past workflow data. In other cases, the past workflow data has already been captured and stored, and the system loads the past workflow data to analyze it. As described herein, the past workflow data can include log files, feature trees, CAD data, interaction capture, requirements, and configurations, among other data, and in particular includes the series of tasks that were performed in the design or simulation of a part to be manufactured, and can include the data need to perform the tasks, including requirements, configurations, log files, simulation and modelling data, and otherwise.

Receiving the past workflow data can be performed by a knowledge extractor component as described herein that extracts relevant knowledge from various sources from past workflows.

The system converts the past workflow data into workflow knowledge (404). In this process, the system can convert the past workflow data from its received or native form into a form suitable for storage in a knowledge graph as described herein. This can include normalizing the data, removing extraneous data, converting the data to use uniform codes or designators, or otherwise. This can include contextualizing actions in the past workflow data with other associative actions in the past workflow data and by adding parametric information associated with each action. This can include combining elements of the past workflow data to provide context for the action, such as by combining data related to a user interaction between two CAD objects and the features, requirements, configurations, or constraints associated with each CAD object to define a context for how the two CAD objects are manipulated together in a sample workflow.

Process 404 can be performed by an extracted knowledge learner component as described herein.

The system stores the workflow knowledge in a contextual knowledge graph (406).

Processes 402-406 discussed above can occur concurrently with the following actions or can be performed before the following processes. The following processes use the contextual knowledge graph discussed above, but the contextual knowledge graph can be dynamic in nature in that it is repeatedly or continuously modified to include new or different workflow knowledge.

The system tracks a current workflow to produce current workflow data (408). The current workflow can be a live user interaction with the system. Tracking the current workflow can include, for example, tracking a log file, an in-progress workflow, new requirements, and/or other data of the current workflow, and producing corresponding current workflow data.

The system converts the current workflow data into current workflow knowledge (410). This can be performed in the same way as process 404 above. Processes 408 and 410 can be performed, for example, by a workflow tracker component as described herein.

The system predicts next actions for the current workflow, based on the current workflow knowledge and the contextual knowledge graph, to produce an automatically created workflow (412). This process can be performed by an inference engine. This process can include identifying patterns in the current workflow knowledge that correspond to one or more nodes in the contextual knowledge graph and identifying the next actions from the contextual knowledge graph.

The system can verify the automatically created workflow with the user (414). This can include displaying the next set of actions to a user, obtaining a user input verifying that the automatically created workflow should be performed, and other actions.

The system can implement or execute the automatically created workflow (416). This can, in some cases, be performed conditionally based on whether the user verified the automatically created workflow. This can include automatically performing the automatically created workflow as if the user were performing them in the current workflow. This can include interacting with another software application, in place of the user, to perform the automatically created workflow, including simulating keyboard, mouse, touch, or other user inputs.

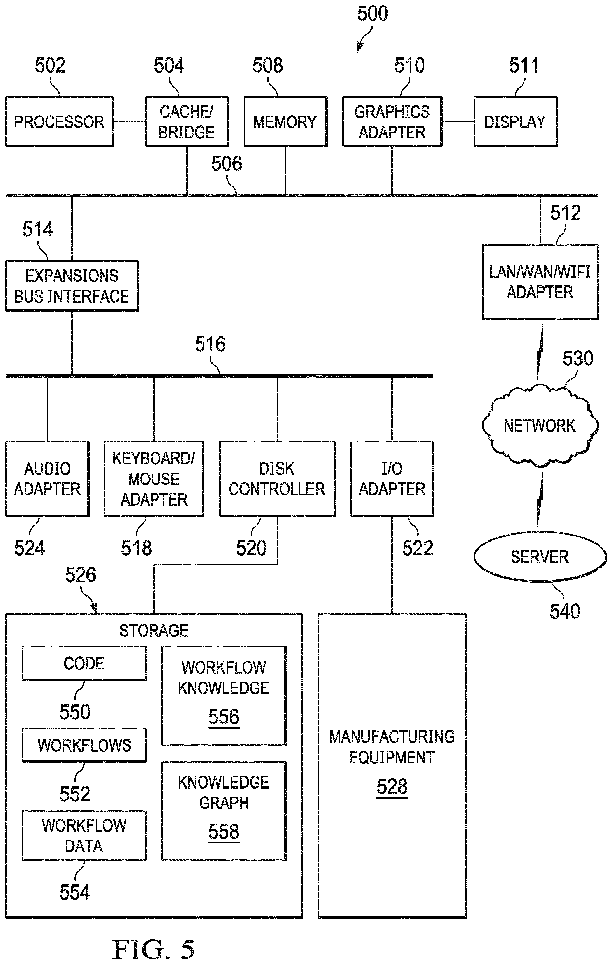

Figure 5 illustrates a block diagram of a data processing system 500 in which an embodiment can be implemented, for example as part of a system as described herein, or as a control system as described herein, particularly configured by software or otherwise to perform the processes as described herein, and in particular as each one of a plurality of interconnected and communicating systems as described herein. The data processing system depicted includes a processor 502 connected to a level two cache/bridge 504, which is connected in turn to a local system bus 506. Local system bus 506 may be, for example, a peripheral component interconnect (PCI) architecture bus. Also connected to local system bus in the depicted example are a main memory 508 and a graphics adapter 510. The graphics adapter 510 may be connected to display 511.

Other peripherals, such as local area network (LAN) / Wide Area Network / Wireless (*e.g.* WiFi) adapter 512, may also be connected to local system bus 506. Expansion bus interface 514 connects local system bus 506 to input/output (I/O) bus 516. I/O bus 516 is connected to keyboard/mouse adapter 518, disk controller 520, and I/O adapter 522. Disk controller 520 can be connected to a storage 526, which can be any suitable machine usable or machine readable storage medium, including but not limited to nonvolatile, hard-coded type mediums such as read only memories (ROMs) or erasable, electrically programmable read only memories (EEPROMs), magnetic tape storage, and user-recordable type mediums such as floppy disks, hard disk drives and compact disk read only memories (CD-ROMs) or digital versatile disks (DVDs), and other known optical, electrical, or magnetic storage devices.

Storage 526 can store any data or code useful for performing processes as described herein, including executable code 550, workflows 552, workflow data 554, workflow knowledge 556, knowledge graph 558, and any other data or code.

Also connected to I/O bus 516 in the example shown is audio adapter 524, to which speakers (not shown) may be connected for playing sounds. Keyboard/mouse adapter 518 provides a connection for a pointing device (not shown), such as a mouse, trackball, trackpointer, touchscreen, etc. I/O adapter 522 can be connected to communicate with or manufacturing equipment 528, which can include any of the devices, additive or subtractive manufacturing equipment, sensors, imagers, systems, or other devices or hardware that can be used to manufacture the part after it is designed, which can be part of any of the processes described herein.

Those of ordinary skill in the art will appreciate that the hardware depicted in Figure 5 may vary for particular implementations. For example, other peripheral devices, such as an optical disk drive and the like, also may be used in addition or in place of the hardware depicted. The depicted example is provided for the purpose of explanation only and is not meant to imply architectural limitations with respect to the present disclosure.

A data processing system in accordance with an embodiment of the present disclosure includes an operating system employing a graphical user interface. The operating system permits multiple display windows to be presented in the graphical user interface simultaneously, with each display window providing an interface to a different application or to a different instance of the same application. A cursor in the graphical user interface may be manipulated by a user through the pointing device. The position of the cursor may be changed and/or an event, such as clicking a mouse button, generated to actuate a desired response.

One of various commercial operating systems, such as a version of Microsoft Windows™, a product of Microsoft Corporation located in Redmond, Wash. may be employed if suitably modified. The operating system is modified or created in accordance with the present disclosure as described.

LAN/ WAN/Wireless adapter 512 can be connected to a network 530 (not a part of data processing system 500), which can be any public or private data processing system network or combination of networks, as known to those of skill in the art, including the Internet. Data processing system 500 can communicate over network 530 with server system 540 (such as cloud systems as described herein), which is also not part of data processing system 500, but can be implemented, for example, as a separate data processing system 500.

Of course, those of skill in the art will recognize that, unless specifically indicated or required by the sequence of operations, certain steps in the processes described above may be omitted, performed concurrently or sequentially, or performed in a different order.

Disclosed embodiments provide systematic, automatic prediction of the workflow actions that a design or simulation engineer might take and can utilize a knowledge graph to systematically capture and learn design engineers' knowledge and experiences. Disclosed embodiments can learn user preferences from the past data. Disclosed embodiments improve the performance of the system by greatly reducing the time and effort needed to perform repetitive modeling and simulation tasks and by enabling partial automation of model and simulation creation tasks.

Those skilled in the art will recognize that, for simplicity and clarity, the full structure and operation of all data processing systems suitable for use with the present disclosure is not being depicted or described herein. Instead, only so much of a data processing system as is unique to the present disclosure or necessary for an understanding of the present disclosure is depicted and described. The remainder of the construction and operation of data processing system 500 may conform to any of the various current implementations and practices known in the art.

It is important to note that while the disclosure includes a description in the context of a fully functional system, those skilled in the art will appreciate that at least portions of the mechanism of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

Although an exemplary embodiment of the present disclosure has been described in detail, those skilled in the art will understand that various changes, substitutions, variations, and improvements disclosed herein may be made without departing from the spirit and scope of the disclosure in its broadest form.

None of the description in the present application should be read as implying that any particular element, step, or function is an essential element which must be included in the claim scope: the scope of patented subject matter is defined only by the allowed claims. Moreover, none of these claims are intended to invoke 35 USC §112(f) unless the exact words "means for" are followed by a participle. The use of terms such as (but not limited to) "mechanism," "module," "device," "unit," "component," "element," "member," "apparatus," "machine," "system," "processor," or "controller," within a claim is understood and intended to refer to structures known to those skilled in the relevant art, as further modified or enhanced by the features of the claims themselves, and is not intended to invoke 35 U.S.C. §112(f).

## Claims

1. A process, comprising:
tracking (408) a current workflow (106), by a data processing system (500), to produce current workflow data (554);
converting (410) the current workflow data (554), by the data processing system (500), into current workflow knowledge (556);
predicting (412) next actions for the current workflow (106), by the data processing system (500), based on the current workflow knowledge (556) and a contextual knowledge graph (144) to produce an automatically created workflow (138); and
implementing (416) the automatically created workflow (138) by the data processing system (500).

2. The process of claim 1, wherein the current workflow (106) includes a series of actions to be performed in the design process of a part to be manufactured.

3. The process of claim 1 or 2, wherein the current workflow (106) includes a series of actions to be performed in the manufacturing planning of a part to be manufactured.

4. The process of any one of claims 1 - 3, wherein the current workflow (106) includes a series of actions to be performed in the simulation setup of a part to be manufactured.

5. The process of any one of claims 1 - 4, further comprising:
receiving past workflow data (554) by the data processing system (500);
converting the past workflow data (554), by the data processing system, into workflow knowledge (556); and
storing the workflow knowledge (556) in the contextual knowledge graph (144).

6. The process of claim 5, wherein converting the past workflow data (554) includes contextualizing actions in the past workflow data (554) with other associative actions in the past workflow data (554) and adding parametric information associated with each action in the past workflow data (554).

7. The process of claim 5 or 6, wherein the past workflow data (554) includes one or more of a log file (110), a feature tree (112), CAD data (114), interaction capture (116), a requirement (118), and a configurations (120).

8. The process of any one of claims 5 - 7, wherein the past workflow data (554) includes a series of actions that were performed in the design of a previous part to be manufactured.

9. The process of claim 8, wherein the past workflow data (554) includes data needed to perform the series of actions that were performed in the design of the previous part to be manufactured, including one or more of requirements (118), configurations (120), log files (110), simulation and modelling data (114).

10. The process of any one of claims 1 - 9, wherein the contextual knowledge graph (144) is repeatedly modified to include different workflow knowledge (556).

11. A data processing system (500), comprising:
a processor (502); and
an accessible memory (508), wherein the data processing system (500) is configured to perform a process as in any of claims 1 - 10.

12. A non-transitory computer-readable medium (526) storing executable instructions (550) that, when executed, cause a data processing system (500) to perform a process as in any of claims 1 - 10.
